# EUROPÄISCHE PATENTSCHRIFT

(11) **EP 2 567 265 B1**
(45) Veröffentlichungstag und Bekanntmachung des Hinweises auf die Patenterteilung: **23.03.2016**
(21) Anmeldenummer: 11717521.6
(22) Anmeldetag: 15.04.2011
(51) Int. Cl.: G01V 3/10

(54) **ERFASSUNG EINES METALLISCHEN ODER MAGNETISCHEN OBJEKTS**
DETECTION OF A METAL OR A MAGNETIC OBJECT
DÉTECTION D'UN OBJET MÉTALLIQUE OU MAGNÉTIQUE

(30) Priorität: 09.07.2010 DE 102010031142; 07.05.2010 DE 102010028721
(43) Veröffentlichungstag der Anmeldung: 13.03.2013
(73) Patentinhaber: Robert Bosch GmbH, 70442 Stuttgart (DE)
(72) Erfinder: ZIBOLD, Tobias, 70567 Stuttgart (DE); ALBRECHT, Andrej, 70567 Stuttgart (DE)
(86) Internationale Anmeldenummer: PCT/EP2011/056023
(87) Internationale Veröffentlichungsnummer: WO 2011/138150

(56) Entgegenhaltungen:
- JP-A- 2005 140 747
- US-A- 4 611 169
- US-A1- 2003 184 301
- US-A1- 2006 238 199
- US-A1- 2007 046 288

## Beschreibung

Bei bestimmten Bearbeitungen von Werkstücken besteht die Gefahr, dass ein im Werkstück verborgener Gegenstand durch die Bearbeitung beschädigt wird. Beispielsweise kann beim Bohren in eine Wand eine Wasser-, Strom- oder Gasleitung beschädigt werden, die innerhalb der Wand verläuft. Im umgekehrten Fall kann es wünschenswert sein, die Bearbeitung gerade so durchzuführen, dass ein im Werkstück verborgener Gegenstand mitbearbeitet wird, beispielsweise wenn das Loch aus dem obigen Beispiel durch ein Armierungseisen oder eine tragende Konstruktion innerhalb der Wand verlaufen soll.

### Stand der Technik

Zur Erfassung eines solchen verborgenen Gegenstandes sind spulenbasierte Metalldetektoren im Stand der Technik bekannt. Derartige Detektoren erzeugen ein magnetisches Feld in einem Messbereich. Befindet sich ein metallischer Gegenstand im Messbereich, so wird der Gegenstand aufgrund seiner Beeinflussung des erzeugten magnetischen Feldes erkannt. Häufig werden zur Bestimmung des erzeugten Magnetfeldes wenigstens zwei Empfangsspulen verwendet, die derartig orientiert und miteinander verbunden sind, dass in Abwesenheit eines metallischen Objekts im Messbereich das von beiden Empfangsspulen gemeinsam gelieferte Messsignal gegen Null geht (differentielle Messung). In einer Variante werden mehrere Sendespulen zur Erzeugung des Magnetfeldes verwendet, die so angesteuert werden, dass unabhängig von einer Anwesenheit eines metallischen Objekts im Messbereich das in den beiden Empfangsspulen gemessene Signal gegen Null geht (feldkompensierte Messung).

DE 10 2007 053 881 A1 beschreibt ein Messverfahren zur Bestimmung der Position bzw. des Winkels einer Spule bezüglich zweier weiterer Spulen. Dazu wird mittels zweier winklig zueinander angeordneter Sendespulen ein magnetisches Wechselfeld generiert. Eine Empfangsspule wird in das magnetische Wechselfeld verbracht und die Ansteuerung der Sendespulen derart verändert, dass in der Empfangsspule von jeder der Sendespulen die gleiche Spannung induziert wird. Ein Verhältnis von den Sendespulen zugeführten Stromwerten dient als Maß für eine Positions- und/oder Winkelbestimmung der Empfangsspule bezüglich der Sendespulen.

DE 10 2004 047 189 A1 beschreibt einen Metalldetektor mit Printspulen.

US 2006/0 238 199 A1, US 4 611 169, US 2003/0 184 301 A1 und JP 2005 140747 beschreiben ähnliche Metall detecktoren.

Der Erfindung liegt die Aufgabe zugrunde, einen einfachen und genauen Detektor für ein metallisches Objekt bereitzustellen. Eine weitere Aufgabe der Erfindung besteht in der Angabe eines Verfahrens zur Bestimmung des metallischen Objekts.

### Offenbarung der Erfindung

Die Erfindung löst diese Aufgaben mittels einer Messvorrichtung mit den Merkmalen des Anspruchs 1 und eines Verfahrens mit den Merkmalen des Anspruchs 10. Unteransprüche geben bevorzugte Ausführungsformen an.

Eine Messvorrichtung zur Erfassung eines metallischen Objekts umfasst zwei Sendespulen zur Erzeugung überlagerter Magnetfelder, eine magnetoresistive Messeinrichtung, insbesondere eine Messeinrichtung mit Hall-Sensoren, im Bereich der beiden Magnetfelder zur Abgabe eines vom Magnetfeld abhängigen Ausgangssignals und eine Steuereinrichtung zur Versorgung der Sendespulen mit alternierenden Spannungen derart, dass ein zu den alternierenden Spannungen taktsynchroner Wechselspannungsanteil des Ausgangssignals der Messeinrichtung betragsmäßig minimiert ist. Dabei ist die Steuereinrichtung dazu eingerichtet, das Objekt zu erfassen, wenn das Verhältnis der alternierenden Spannungen nicht zum Verhältnis der Abstände der Messeinrichtung zu den Sendespulen korrespondiert.

Die Messvorrichtung kann eine feldkompensierte und differentielle Messung vornehmen und dadurch ein genaues Messergebnis liefern, das robust gegenüber Störungen ist. Außerdem können magnetoresistive Messeinrichtungen verwendet werden, die wesentlich kleiner sind als übliche Spulen zur Bestimmung von Magnetfeldern. Dadurch ist ein sehr kompakter Aufbau der Messvorrichtung möglich und hochgradig integrierte Messanordnungen in enger räumlicher Nachbarschaft können ermöglicht sein. Im Gegensatz zu Spulen messen magnetoresistive Sensoren das Magnetfeld und nicht die zeitliche Änderung des magnetischen Flusses. Bei der Erzeugung alternierender Felder mittels Rechtecksignalen hat dies den Vorteil, dass der Einfluss des Objektes nicht nur während der kurzen Zeit der Feldänderung im Bereich der Flanke, sondern während der gesamten Dauer der Halbwelle der Rechteckanregung gemessen werden kann. Hierdurch kann die Messgenauigkeit gesteigert sein.

Vorzugsweise sind die alternierenden Spannungen um zueinander phasenverschobene, vorzugsweise um 180° phasenverschobene, Wechselspannungen, um die Magnetfelder der Sendespulen periodisch in Betrag und Phase zu ändern. Die Wechselspannungen ermöglichen die Synchrondemodulation, womit störende Signale mit Frequenzen ungleich der Modulationsfrequenz sehr effektiv unterdrückt werden können. Darüber hinaus können durch die Wechselspannungen wechselnde Magnetfelder erzeugt werden, um Wirbelstöme in nichtmagnetischen Materialien wie z.B. Kupfer zu induzieren, aufgrund derer diese dann detektiert werden können.

In einer ersten Variante kann die Messeinrichtung mehrere voneinander beabstandete Sensoren zur Magnetfeldbestimmung umfassen, wobei die Sensoren derart zueinander ausgerichtet und miteinander verbunden sind, dass sich Ausgangssignale der Sensoren bei gleichen Magnetfeldern an den Sensoren zu Null addieren und Hauptfeldrichtungen der Sendespulen und Vorzugsrichtungen der Sensoren parallel zueinander sind. Beispielsweise können antiparallel orientierte Hall-Sensoren in einer seriellen Verschaltung verwendet werden, um kostengünstig und präzise ein resultierendes Magnetfeld im Bereich der beiden Sendespulen zu bestimmen.

Die Sensoren können Vorzugsrichtungen aufweisen, die parallel zueinander verlaufen, und die Signale der Sensoren können voneinander subtrahiert werden. Alternativ dazu können die Vorzugsrichtungen der Sensoren antiparallel ausgerichtet sein und die Signale der Sensoren miteinander addiert werden. Zur Addition bzw. Subtraktion kann ein Differenzverstärker verwendet werden oder die Sensoren können entsprechend miteinander verschaltet werden.

Prinzipiell ist jede Art von Sensor geeignet, der ein Magnetfeld bestimmt. Derartige Sensoren können kleine Abmessungen aufweisen, so dass die Messeinrichtung miniaturisiert werden kann. Eine räumliche Auflösung kann dadurch gesteigert sein, in einer Ausführungsform bis in einen bildhaft darstellbaren Bereich hinein.

Vorteilhafterweise liegen die Sendespulen in zueinander parallelen Ebenen übereinander, wodurch eine matrixartige Anordnung einer Vielzahl von Sendespulen für eine oder mehrere Messeinrichtungen erleichtert wird. Die Sendespulen können Luftspulen und insbesondere auf einer Platine ausgebildete gedruckte Schaltungen ("Printspulen") sein, so dass eine Fertigung wenig aufwendig und damit kostengünstig sein kann.

Einer der Sensoren kann von einer der Sendespulen umlaufen werden und ein anderer der Sensoren kann außerhalb der Sendespule liegen. Durch Wahl der konkreten Positionen der Sensoren können zwei oder mehr Sensoren verwendet werden, um in Summe ein zum resultierenden Magnetfeld proportionales Signal abzugeben, das sich auf mehrere Punkte im Bereich der Sendespulen bezieht.

In einer zweiten Variante kann die Messeinrichtung einen Sensor zur Bestimmung eines Magnetfeldgradienten umfassen, wobei Hauptfeldrichtungen der Sendespulen parallel zueinander verlaufen und eine Vorzugsrichtung des Sensors senkrecht oder parallel zu den Hauptfeldrichtungen verläuft. Sensoren für Gradienten von Magnetfeldern sind in hoher Präzision verfügbar, beispielsweise als AMR- (Anisotroper Magnetoresistiver Effekt), GMR- (Gigantischer Magnetoresistiver Effekt), CMR- (Kolossaler Magnetoresistiver Effekt), TMR- (Tunnel Magneto-Widerstand) oder planare Hall-Sensoren. Derartige Sensoren sind zudem als Standardbauteile preisgünstig erhältlich. In einer weiteren Ausführungsform kann auch ein nicht auf dem magnetoresistiven Effekt basierender Sensor, wie beispielsweise ein SQUID-Sensor, verwendet werden.

Die Sendespulen können im Wesentlichen nebeneinander in einer Ebene angeordnet sein, wobei die Vorzugsrichtung des Sensors parallel oder senkrecht zu dieser Ebene verläuft. Dadurch kann eine Messanordnung auf einer nur einseitig bestückten Platine untergebracht werden, was einen Stückpreis der Messvorrichtung senken kann.

Die Sendespulen können im wesentlichen D-förmig sein, wobei die Rücken der D-Formen einander zugewandt sind und der Sensor zwischen den Rücken der D-Formen angeordnet ist. So kann ein sehr kompakter Aufbau im Zusammenhang mit einem Sensor für Magnetfeldgradienten realisiert werden.

Vorzugsweise ist der Sensor im Wesentlichen in der Ebene der Sendespulen angeordnet und ein weiterer Sensor ist in einer zu dieser Ebene parallelen Ebene vorgesehen, wobei Vorzugsrichtungen des Sensors und des weiteren Sensors aufeinander senkrecht stehen. Dadurch können eine Genauigkeit und Universalität der Messvorrichtung gesteigert sein.

Ferner umfasst die Erfindung ein Messverfahren zur Erfassung eines metallischen Objekts Schritte des Versorgens zweier Sendespulen mit alternierenden Spannungen, um überlagerte Magnetfelder zu erzeugen, des Bestimmens eines vom Magnetfeld abhängigen Ausgangssignals einer magnetoresistiven Messeinrichtung im Bereich der beiden Magnetfelder, wobei das Versorgen der Sendespulen mit alternierenden Spannungen derart erfolgt, dass ein zu den alternierenden Spannungen taktsynchroner Wechselspannungsanteil des Ausgangssignals der Messeinrichtung betragsmäßig minimiert ist, und des Erfassens des Objekts, wenn das Verhältnis der alternierenden Spannungen nicht zu einem Verhältnis der Abstände der Messeinrichtung zu den Sendespulen korrespondiert.

### Kurze Beschreibung der Figuren

Im Folgenden wird die Erfindung mit Bezug auf die beigefügten Figuren genauer beschrieben, in denen:
- Figur 1: ein Blockschaltbild einer Messvorrichtung;
- Figur 2: eine Anordnung von magnetoresistiven Messeinrichtungen für die Messvorrichtung aus Figur 1;
- Figur 3: Anordnungen mehrerer Sendespulen an der Messvorrichtung aus Figur 1;
- Figur 4: Anordnungen von Magnetfeldsensoren und Sendespulen für die Messvorrichtung aus Figur 1;
- Figur 5: Anordnungen von Magnetfeldgradientsensoren und Sendespulen für die Messeinrichtung aus Figur 1; und
- Figur 6: ein Ablaufdiagramm eines Verfahrens zur Erfassung eines metallischen Objekts mit der Messvorrichtung aus Figur 1 darstellt.

### Genaue Beschreibung von Ausführungsbeispielen

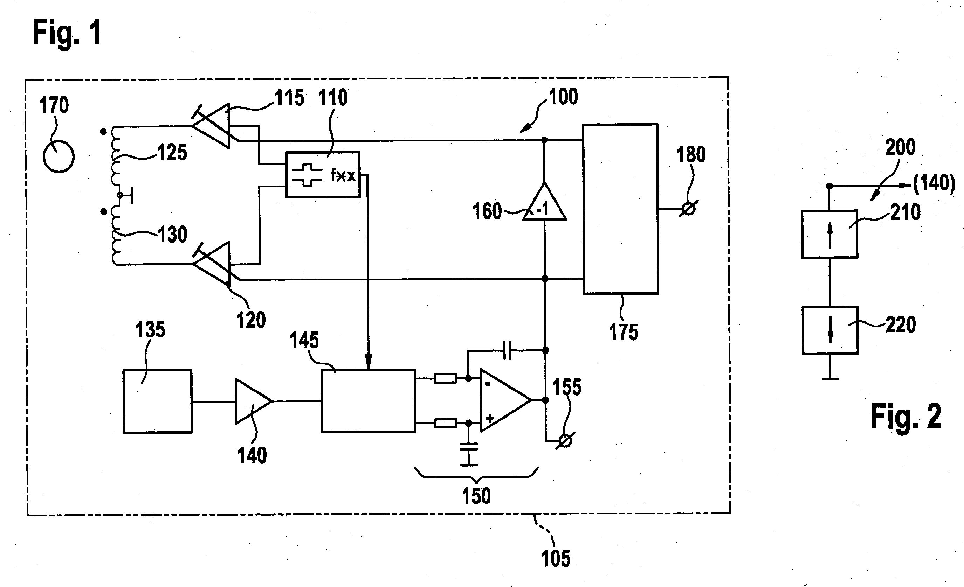

Figur 1 zeigt ein Blockschaltbild einer Messvorrichtung 100. Die Messvorrichtung 100 ist Teil eines Metalldetektors 105 zum Erfassen metallischer Objekte, beispielsweise aus eisenhaltigem Material.

Ein Taktgenerator 110 hat zwei Ausgänge, an denen er phasenverschobene, vorzugsweise um 180° phasenverschobene, periodische Wechselsignale bereitstellt. Die Wechselsignale können insbesondere Rechteck-, Dreieck- oder Sinussignale umfassen. Die Ausgänge des Taktgenerators sind mit einem ersten steuerbaren Verstärker 115 bzw. einem zweiten steuerbaren Verstärker 120 verbunden. Jeder der steuerbaren Verstärker 115, 120 verfügt über einen Steuereingang, über den er ein Signal entgegennimmt, welches einen Verstärkungsfaktor des steuerbaren Verstärkers 115, 120 steuert. Ein Ausgang des ersten steuerbaren Verstärkers 115 ist mit einer ersten Sendespule 125 und ein Ausgang des zweiten steuerbaren Verstärkers 120 mit einer zweiten Sendespule 130 verbunden. Verbleibende Enden der Sendespulen 125 und 130 sind jeweils elektrisch mit einem definierten Potential verbunden.

Wie durch die Punkte an den Sendespulen 125 und 130 angedeutet ist, sind die Sendespulen 125 und 130 gegensinnig orientiert. Bei Versorgung mit bezüglich des definierten Potentials entgegengesetzten Spannungen bauen die Sendespulen 125, 130 magnetische Felder mit gleicher Ausrichtungen auf.

Der gleiche Effekt kann auch erzielt werden bei Versorgung mit bezüglich des definierten Potentials gleichgerichteter Spannung mit alternierend unterschiedlicher Amplitude, in diesem Fall fließen Ströme mit überlagertem Gleichanteil. In diesem Fall ergibt sowohl die gleichsinnige, als auch die gegensinnige Orientierung der Sendespule Sinn. Die Magnetfeldsensoren sind in allen Fällen dergestalt zueinander auszurichten und zu verschalten, dass im objektfreien Fall ein konstantes Signal am Ausgang der magnetoresistiven Messvorrichtung 135 anliegt. Dieser Signalanteil entspricht dem überlagerten Gleichanteil der Ströme. Um den Eingangsverstärker 140 nicht unötig auszusteuern, kann der Eingangsverstärker mit einem Kondensator gleichspannungsentkoppelt werden.

Eine magnetoresistive Messeinrichtung 135 ist mit einem Eingangsverstärker 140 verbunden. Der Eingangsverstärker 140 ist mit einem konstanten Verstärkungsfaktor dargestellt; in anderen Ausführungsformen kann jedoch ein Verstärkungsfaktor des Eingangsverstärkers 140 auch steuerbar sein. Dadurch kann beispielsweise eine räumliche Auflösung und/oder Empfindlichkeit der Messvorrichtung 100 beeinflussbar und beispielsweise in Abhängigkeit einer Messgröße steuerbar sein.

Der Ausgang des Eingangsverstärkers 140 ist mit einem Synchrondemodulator 145 verbunden. Der Synchrondemodulator 145 ist ferner mit dem Taktgenerator 110 verbunden und empfängt von diesem ein Taktsignal, welches auf die Phasenlage der an den Ausgängen des Taktgenerators 110 bereitgestellten Signale hinweist. In einer einfachen Ausführungsform, bei der die vom Taktgenerator 110 bereitgestellten Signale symmetrische Rechtecksignale sind, kann eines der Ausgangssignale als Taktsignal verwendet werden. Der Synchrondemodulator 145 schaltet im Wesentlichen auf der Basis des vom Taktgenerator 110 bereitgestellten Taktsignals das vom Eingangsverstärker 140 empfangene Messsignal alternierend an seinem oberen bzw. unteren Ausgang durch.

Die beiden Ausgänge des Synchrondemodulators 145 sind mit einem Integrator (integrierenden Komparator) 150 verbunden, der hier als mit zwei Widerständen und zwei Kondensatoren beschalteter Operationsverstärker dargestellt ist. Andere Ausführungsformen sind ebenfalls möglich, beispielsweise als aktiver Tiefpass. Auch eine digitale Ausführung im Anschluss an den Synchrondemodulator ist denkbar, bei der das Signal an den Ausgängen des Synchrondemodulators zu einem oder mehreren Zeitpunkten innerhalb einer Halbwelle analog zu digital gewandelt wird und dann mit dem entsprechenden Wert aus der nächsten Halbwelle verglichen wird. Die Differenz wird integriert und z.B. wieder in ein analoges Signal überführt und zur Steuerung der Verstärker verwendet. Während der Synchrondemodulator 145 das vom Eingangsverstärker 140 empfangene Messsignal am unteren seiner Ausgänge bereitstellt, integriert der Integrator 150 dieses Signal über die Zeit und stellt das Resultat an seinem Ausgang bereit. Während der Synchrondemodulator 145 das vom Eingangsverstärker 140 empfangene Messsignal an seinem oberen Ausgang bereitstellt, wird dieses vom Integrator 150 invertiert über die Zeit integriert und das Resultat am Ausgang des Intergrators 150 bereitgestellt. Die Spannung am Ausgang des Integrators 150 ist das Integral der Differenz der tiefpassgefilterten Ausgänge des Synchrondemodulators 145.

Ist das überlagerte Magnetfeld der Sendespulen 125 und 130 an der magnetoresistiven Messeinrichtung 135 in Betrag und Richtung gleich groß, so sind die an den Ausgängen des Synchrondemodulators 145 bereitgestellten Signale im Mittel über die Zeit gleich groß und am Ausgang des Integrators 150 wird ein Signal bereitgestellt, das gegen Null (Masse) geht. Überwiegt jedoch der Einfluss des Magnetfeldes einer der Sendespulen 125, 130, so sind die an den Ausgängen des Synchrondemodulators 145 bereitgestellten Signale im Mittel nicht mehr gleich, und am Ausgang des Integrators 150 wird ein positives oder negatives Signal bereitgestellt.

Das vom Integrator 150 bereitgestellte Signal wird über einen Anschluss 155 zur weiteren Verarbeitung bereitgestellt. Zusätzlich ist ein Mikrocomputer 175 mit den Steuereingängen der steuerbaren Verstärker 115, 120 verbunden. Der Mikrocomputer 175 führt einen Vergleich des bereitgestellten Signals mit einem Schwellenwert durch und gibt an einem Ausgang 180 ein Signal aus, welches auf das metallische Objekt hinweist. Das Signal kann in optischer und/oder akustischer Weise einem Benutzer des Metalldetektors 105 dargeboten werden.

Der Mikrocomputer 175 kann darüber hinaus eine weitere Verarbeitung der von den Steuereingängen der steuerbaren Verstärker 115, 120 abgegriffenen Signale durchführen und in deren Abhängigkeit Parameter der Messvorrichtung 100 steuern. Beispielsweise kann eine Frequenz oder Signalform der alternierenden Spannungen an den Ausgängen des Taktgenerators 110 variiiert oder eine Empfindlichkeit des Empfangsverstärkers 140 geändert werden. In einer weiteren Ausführungsform sind weitere der gezeigten Elemente der Messvorrichtung 100 durch den Mikrocomputer 175 implementiert, etwa der Taktgenerator 110, der Synchrondemodulator 145 oder der Integrator 150.

Das gleiche Signal des Integrators 150 wird auch zur Steuerung der Verstärkungsfaktoren der steuerbaren Verstärker 115 und 120 verwendet, wobei der zweite steuerbare Verstärker 120 unmittelbar mit dem Ausgang des Integrators 150 verbunden ist und der erste steuerbare Verstärker 115 mittels eines Inverters 160 mit dem Ausgang des Integrators 150 verbunden ist. Der Inverter 160 bewirkt eine Umkehrung des ihm bereitgestellten Signals derart, dass in Abhängigkeit des Ausgangssignals des Integrators 150 der Verstärkungsfaktor des ersten steuerbaren Verstärkers 115 in dem Maß zunimmt wie der Verstärkungsfaktor des zweiten steuerbaren Verstärkers 120 abnimmt bzw. umgekehrt. Es ist auch denkbar, dass nur der Verstärkungsfaktor eines der steuerbaren Verstärker gesteuert wird, während der Verstärkungsfaktor des zweiten steuerbaren Verstärkes auf einem festen Wert gehalten wird.

Im Bereich der Sendespulen 125, 130 ist ein metallisches Objekt 170 eingezeichnet. Das metallische Objekt 170 hat unterschiedliche Abstände zu den Sendespulen 125 und 130 und beeinflusst daher gleich starke Magnetfelder der Sendespulen 125, 130 unterschiedlich stark. Die Messvorrichtung 100 ist dazu eingerichtet, diese Beeinflussung über eine gegenläufige Änderung der Verstärkungsfaktoren der steuerbaren Verstärker 115, 120 auszubalancieren. Wird nur einer der beiden steuerbaren Verstärker 115, 120 gesteuert und der andere festgehalten, so wird nicht durch eine gegenläufige Änderung ausbalanciert, sondern lediglich mit einer gerichteten Änderung.

Figur 2 zeigt eine Anordnung 200 zweier magnetoresistiver Magnetfeldsensoren zum Einsatz mit der Messeinrichtung von Figur 1. Ein erster Hall-Sensor 210 und ein zweiter Hall-Sensor 220 weisen entgegengesetzte Vorzugsrichtungen auf und sind derart miteinander seriell verschaltet, dass sie in einem homogenen Magnetfeld in Summe ein Signal von Null bereitstellen. Die Hall-Sensoren 210, 220 sind mit ihren Vorzugsrichtungen parallel (210) bzw. antiparallel (220) zur Hauptfeldrichtung des im objektfreien Fall von den Sendespulen erzeugten Magnetfeldes ausgerichtet. Das Signal der Hall-Sensoren 210, 220 wird an den Eingangsverstärker 140 in Figur 1 weitergeleitet.

Notwendigerweise sind die Hall-Sensoren 210 und 220 mit einem gewissen Abstand zueinander angeordnet, so dass sie Magnetfelder an unterschiedlichen Orten messen. Ein Ausgangssignal der Sensoren 210, 220 ergibt sich dann, wenn die Sensoren 210, 220 in ihren Vorzugsrichtungen unterschiedlich starken Magnetfeldern ausgesetzt sind. Dies ist beispielsweise dann der Fall, wenn das Magnetfeld einer der Sendespulen 125, 130 aus Figur 1 durch ein metallisches Objekt stärker als das Magnetfeld der anderen Sendespule 125, 130 beeinflusst ist. Aufgrund der Beeinflussung der Magnetfelder durch ein metallisches Objekt ergibt sich im Besonderen ein von Null verschiedener taktsynchroner Wechselspannungsanteil im Ausgangssignal der magnetoresistiven Messeinrichtung. Die Messvorrichtung 100 verändert in diesem Fall die Spannungen, mit denen die Sendespulen 125, 130 versorgt werden, gegenläufig, bis die Magnetfelder an den Hall-Sensoren 210, 220 wieder gleich stark in den jeweiligen Vorzugsrichtungen sind. Die am Anschluss 155 anliegende Spannung kann als Maß für die Ungleichheit der alternierenden Spannungen der Sendespulen 125, 130 ausgewertet werden.

In einer zweiten Variante werden an Stelle der Hall-Sensoren 210, 220, die Magnetfelder bestimmen, Sensoren zur Bestimmung von Magnetfeldgradienten verwendet, die dann senkrecht zu einem im objektfreien Fall ausgerichteten Magnetfeld orientiert sind. In noch einer Ausführungform ist lediglich ein solcher Magnetfeldgradienten-Sensor vorgesehen.

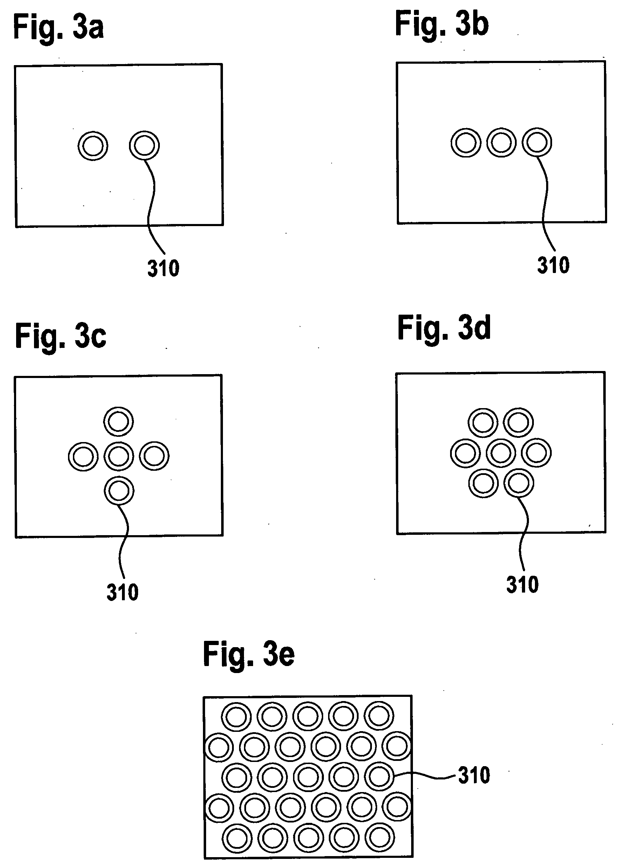

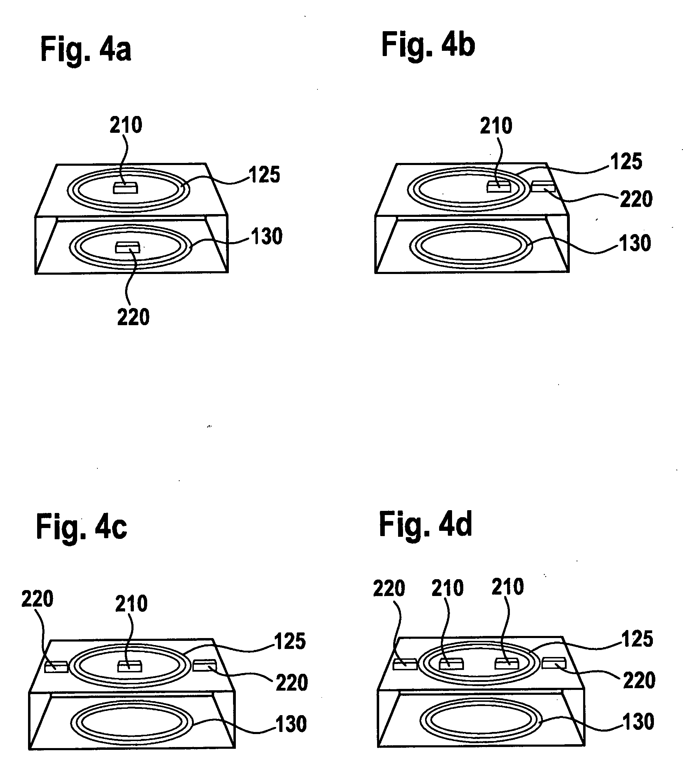

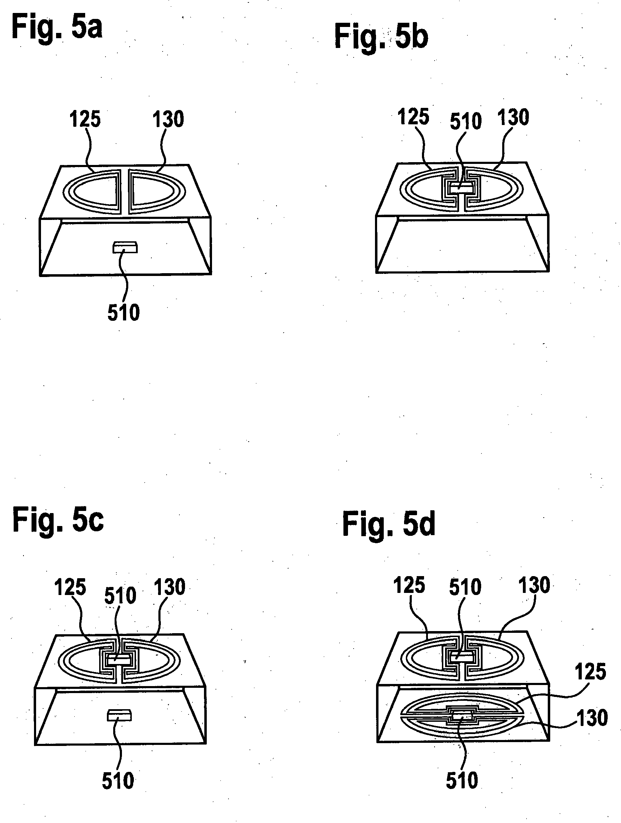

Figur 3 zeigt Anordnungen von Sendespulen an der Messvorrichtung 100 aus Figur 1. Der Übersichtlichkeit halber sind übereinander liegende Paare von Sendespulen 125/130 als Kreise wiedergegeben; Magnetfeld- oder Magnetfeldgradientensensoren sind nicht dargestellt. Jeder der Kreise entspricht einer der in Fig. 4 oder Fig. 5 dargestellten Anordnungen. Zur Ansteuerung der Anordnungen 310 sind eine oder mehrere Messvorrichtungen 100 vorgesehen, wobei jede Messvorrichtung 100 während einer Messung nur mit einer der Anordnungen 310 verbunden ist. Es kann eine Umschaltung mehrerer Anordnungen 310 an eine der Messvorrichtungen 100 erfolgen. Durch entsprechende geometrische Verteilung einer Vielzahl von Anordnungen 310 können Richtungs-, Tiefen- oder Größeninformationen des zu erfassenden metallischen Objekts bestimmt werden.

Eine Tiefenbestimmung ist mit den Anordnungen der Figuren 3a oder 3b möglich. Eine Richtungs- bzw. Orientierungsbestimmung kann mit den Anordnungen der Figuren 3c oder 3d durchgeführt werden. Die Anordnung in Figur 3e kann zur Bildgebung eingesetzt werden.

Figur 4 zeigt Anordnungen von Magnetfeldsensoren und Sendespulen für die Messvorrichtung aus Figur 1. Alle in Figur 4 dargestellten Magnetfeldsensoren sind mit der Vorzugsrichtungsrichtung, in der sie einem Magnetfeld ausgesetzt werden müssen, um ein maximales Ausgangssignal zu generieren, in der Vertikalen, also parallel zu einem Hauptmagnetfeld ausgerichtet, das innerhalb der Sendespulen 125, 130 herrscht. Abweichungen der Vorzugsrichtungen der Magnetfeldsensoren von den angegebenen Ausrichtungen sind unschädlich so lange die Abweichungen ausreichend klein sind, dass die Magnetfeldsensoren das Magnetfeld in der verwendeten Ausrichtung bestimmen können. Die Sendespulen 125, 130 sind als kernlose Printspulen auf gegenüberliegenden Seiten einer Platine ausgebildet.

In Figur 4a sind die Hall-Sensoren 210 und 220 aus Figur 2 jeweils zentriert in einer der Sendespulen 125 bzw. 130 angeordnet. Die Ausrichtung der Hall-Sensoren 210 und 210 ist antiparallel und ihre Verschaltung parallel wie in Figur 2 gezeigt.

In Figur 4b sind die Hall-Sensoren 210 und 220 parallel ausgerichtet und parallel verschaltet. Das von den Sendespulen 125, 130 erzeugte Magnetfeld hat innerhalb und außerhalb der Sendespulen 125, 130 unterschiedliche Richtung. Die Hall-Sensoren 210, 220 haben einen derartigen Abstand von den Windungen der Sendespulen 125,130, dass die Beträge der Magnetfelder im objektfreien Fall einander entsprechen.

In Figur 4c ist im Unterschied zur Darstellung von Figur 4b ein weiterer zweiter Hall-Sensor 220 vorgesehen, wobei die beiden zweiten Hall-Sensoren 220 einander bezüglich des ersten Hall-Sensors 210 gegenüber liegen. Die Ausrichtung der Hall-Sensoren ist parallel, wobei die Abstände der zweiten Hall-Sensoren 220 von den Windungen der Sendespulen derart gewählt sind, dass die Beträge der an den zweiten Hall-Sensoren 220 herrschenden Magnetfelder im objektfreien Fall in Summe dem Betrag des am ersten Hall-Sensor herrschenden Magnetfeldes entsprechen. Die Hall-Sensoren 210, 220 sind so verschaltet, dass sich ihre Ausgangssignale addieren.

In Figur 4d ist das Prinzip der Anordnung von Figur 4c weitergetragen, indem ein zusätzlicher erster Hall-Sensor 210 im Inneren der ersten Sendespule 125 vorgesehen ist. Die Hall-Sensoren sind so verschaltet, dass ihre Ausgangssignale addiert werden. Alle Hall-Sensoren sind parallel zueinander ausgerichtet. Die Abstände der Hall-Sensoren zu den Windungen der Sendespule 125 sind so gewählt, dass die Summe der Beträge der an den ersten Hall-Sensoren 210 herrschenden Magnetfelder der Summe der Beträge der an den zweiten Hall-Sensoren 220 herrschenden Magnetfelder entspricht.

Figur 5 zeigt Anordnungen von Magnetfeldgradientsensoren und Sendespulen für die Messeinrichtung aus Figur 1. Im Unterschied zu den Darstellungen von Figur 4 sind die verwendeten Sensoren Magnetfeldgradientensensoren 510, deren Vorzugsrichtungen parallel zur Oberfläche der dargestellten Platine verlaufen. In einer anderen Ausführungsform verlaufen die Vorzugsrichtungen der Magnetfeldgradientensensoren parallel zur Hauptfeldrichtung. Auch hier sind Abweichungen der Vorzugsrichtungen der Magnetfeldgradientensensoren von den angegebenen Ausrichtungen unschädlich so lange die Abweichungen ausreichend klein sind, dass die Magnetfeldgardientensensoren das Magnetfeld in der verwendeten Ausrichtung bestimmen können.

Mehrere Magnetfeldgradientensensoren 510 sind jeweils derart miteinander verschaltet, dass sich ihre Ausgangssignale addieren. Denkbar ist auch, dass die Magnetfeldgradientensensoren 510 getrennt ausgewertetet werden, z.B. nacheinander. Hierzu müssen die Ausgänge der Magnetfeldsensoren 510 durch einen Schalter alternierend mit dem Eingang des Eingangsverstärkers 140 verbunden werden.

In Figur 5a sind die Sendespulen 125,130 auf gegenüberliegenden Seiten der Platine ausgebildet. Die Sendespulen 125, 130 befinden sich nebeneinander und haben im Wesentlichen eine D-Form, wobei die Rücken der D-Formen parallel und einander zugewandt sind. Die Vorzugsrichtung des Magnetfeldgradientensensors 510 schließt mit der Richtung der Rücken der D-Formen einen Winkel von 90° ein.

In Figur 5b ist im Unterschied zur Darstellung in Figur 5a der Magnetfeldgradientensensor 510 auf der gleichen Seite der Platine wie die Sendespulen 125, 130 angeordnet. Die Rücken der D-Formen umlaufen die Stelle, an der der Magnetfeldgradientensensor 510 liegt.

In Figur 5c ist zusätzlich zur Darstellung in Figur 5b ein weiterer Magnetfeldgradientensensor 510 auf der unteren Seite der Platine vorgesehen. Die Vorzugsrichtung des oberen Magnetfeldgradientensensors 510 steht auf der Richtung der Rücken der D-Formen senkrecht und die Vorzugsrichtung des unteren Magnetfeldgradientensensors 510 steht auf der Vorzugsrichtung des oberen Magnetfeldgradientensensors 510 senkrecht. In einer weiteren Ausführungsform können auch beide Vorzugsrichtungen auf der Richtung der Rücken der D-Formen senkrecht stehen.

In Figur 5d ist je eine Anordnung von Figur 5b auf der Ober- und Unterseite der Platine angeordnet, wobei die Anordnungen in der Platinenebene um 90° gegeneinander verdreht sind. Die Vorzugsrichtungen der Magnetfeldgradientensensoren 510 stehen aufeinander senkrecht.

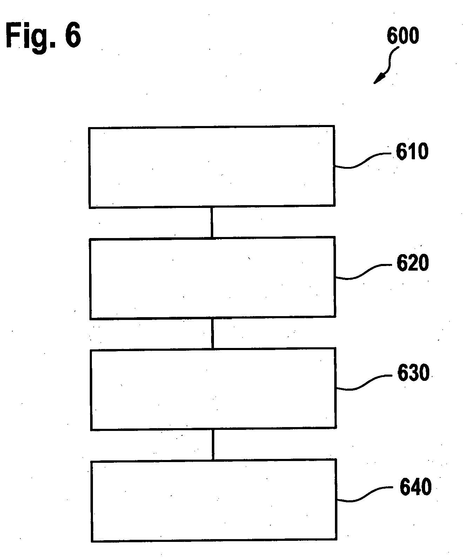

Figur 6 zeigt ein Ablaufdiagramm 600 eines Verfahrens zur Erfassung eines metallischen Objekts mit der Messvorrichtung aus Figur 1. In einem ersten Schritt 610 werden die Sendespulen 125, 130 mit alternierenden Spannungen versorgt, um entgegengesetzt orientierte Magnetfelder zu erzeugen. Danach wird in einem Schritt 620 ein vom Magnetfeld abhängiges Ausgangssignal einer magnetoresistiven Messeinrichtung im Bereich der beiden Magnetfelder bestimmt. In Abhängigkeit des taktsynchronen Wechselspannungsanteils des bestimmten Signals wird in einem Schritt 630 das Versorgen der Sendespulen mit alternierenden Spannungen derart durchgeführt, dass der taktsynchrone Wechselspannungsanteil des Ausgangssignals der Messeinrichtung betragsmäßig minimiert ist. Schließlich wird in einem Schritt 640 das metallische Objekt erfasst, wenn das Verhältnis der alternierenden Spannungen nicht zu einem Verhältnis der Abstände der Messeinrichtung zu den Sendespulen korrespondiert.

## Patentansprüche

1. Messvorrichtung (100) zur Erfassung eines metallischen Objekts (170), wobei die Messvorrichtung (100) Folgendes umfasst:
- zwei Sendespulen (125, 130) zur Erzeugung überlagerter Magnetfelder;
- eine magnetoresistive Messeinrichtung (135, 510) im Bereich der beiden Magnetfelder zur Abgabe eines vom Magnetfeld abhängigen Ausgangssignals;
- eine Steuereinrichtung (110-120, 145-160) zur Versorgung der Sendespulen (125, 130) mit alternierenden Spannungen derart, dass ein zu den alternierenden Spannungen taktsynchroner Wechselspannungsanteil des Ausgangssignal der Messeinrichtung (135, 510) betragsmäßig minimiert ist;
**dadurch gekennzeichnet, dass**
- die Steuereinrichtung (110-120, 145-160) dazu eingerichtet ist, das Objekt zu erfassen, wenn das Verhältnis der alternierenden Spannungen nicht zum Verhältnis der Abstände der Messeinrichtung (135, 510) zu den Sendespulen (125, 130) korrespondiert.

2. Messvorrichtung (100) nach einem der vorangehenden Ansprüche, **dadurch gekennzeichnet, dass** die alternierenden Spannungen zueinander phasenverschobene Wechselspannungen sind, um die Magnetfelder der Sendespulen (125, 130) periodisch in Betrag und Phase zu ändern.

3. Messvorrichtung (100) nach Anspruch 1 oder 2, **dadurch gekennzeichnet, dass**
- die Messvorrichtung mehrere voneinander beabstandete Sensoren (210, 220) zur Magnetfeldbestimmung umfasst,
- wobei die Sensoren (210, 220) derart zueinander ausgerichtet und miteinander verbunden sind, dass sich Ausgangssignale der Sensoren (210, 220) bei gleichen Magnetfeldern an den Sensoren (210, 220) zu Null addieren und
- Hauptfeldrichtungen der Sendespulen (125, 130) und Vorzugsrichtungen der Sensoren (210, 220) im Wesentlichen parallel zueinander sind.

4. Messvorrichtung (100) nach Anspruch 3, **dadurch gekennzeichnet, dass** die Sendespulen (125, 130) in zueinander parallelen Ebenen übereinander liegen.

5. Messvorrichtung (100) nach Anspruch 3 oder 4, **dadurch gekennzeichnet, dass** einer der Sensoren (210, 220) von einer der Sendespulen (125, 130) umlaufen wird und ein anderer der Sensoren (210, 220) außerhalb der Sendespulen (125, 130) liegt.

6. Messvorrichtung (100) nach Anspruch 1 oder 2, **dadurch gekennzeichnet, dass**
- die Messvorrichtung (100) einen Sensor (510) zur Bestimmung eines Magnetfeldgradienten umfasst,
- Hauptfeldrichtungen der Sendespulen (125, 130) parallel zueinander verlaufen und
- eine Vorzugsrichtung des Sensors (510) im Wesentlichen senkrecht oder parallel zu den Hauptfeldrichtungen verläuft.

7. Messvorrichtung (100) nach Anspruch 6, **dadurch gekennzeichnet, dass** die Sendespulen (125, 130) im Wesentlichen nebeneinander in einer Ebene angeordnet sind und die Vorzugsrichtung des Sensors (510) im Wesentlichen parallel zu dieser Ebene verläuft.

8. Messvorrichtung (100) nach Anspruch 6 oder 7, **dadurch gekennzeichnet, dass** die Sendespulen (125, 130) im Wesentlichen D-förmig sind, wobei die Rücken der D-Formen einander zugewandt sind und der Sensor (510) zwischen den Rücken der D-Formen angeordnet ist.

9. Messvorrichtung (100) nach Anspruch 7 oder 8, **dadurch gekennzeichnet, dass** der Sensor (510) im Wesentlichen in der Ebene der Sendespulen (125, 130) angeordnet ist und ein weiterer Sensor (510) in einer zu dieser Ebene parallelen Ebene vorgesehen ist, wobei Vorzugsrichtungen des Sensors (510) und des weiteren Sensors (510) aufeinander senkrecht oder parallel stehen.

10. Messverfahren (600) zur Erfassung eines metallischen Objekts (170), folgende Schritte umfassend:
- Versorgen (610, 630) zweier Sendespulen (125, 130) mit alternierenden Spannungen, um überlagerte Magnetfelder zu erzeugen;
- Bestimmen (620) eines vom Magnetfeld abhängigen Ausgangssignals einer magnetoresistiven Messvorrichtung im Bereich der beiden Magnetfelder;
- wobei das Versorgen (610, 630) der Sendespulen (125, 130) mit alternierenden Spannungen derart erfolgt, dass ein zu den alternierenden Spannungen taktsynchroner Wechselspannungsanteil des Ausgangssignal der Messeinrichtung (135, 510) betragsmäßig minimiert ist; und **gekennzeichnet durch**
- Erfassen (640) des Objekts (170), wenn das Verhältnis der alternierenden Spannungen nicht zu einem Verhältnis der Abstände der Messeinrichtung zu den Sendespulen (125, 130) korrespondiert.

11. Computerprogrammprodukt mit Programmcodemitteln zur Durchführung des Verfahrens (600) von Anspruch 10, wenn das Computerprogrammprodukt auf einer Verarbeitungseinrichtung abläuft oder auf einem computerlesbaren Datenträger abgespeichert ist.

## Claims

1. Measuring apparatus (100) for detecting a metallic object (170), wherein the measuring apparatus (100) comprises the following:
- two transmitting coils (125, 130) for generating superimposed magnetic fields;
- a magnetoresistive measuring device (135, 510) in the region of the two magnetic fields for providing an output signal dependent on the magnetic field;
- a control device (110-120, 145-160) for supplying the transmitting coils (125, 130) with alternating voltages in such a way that the magnitude of an AC voltage component, which is synchronous with the alternating voltages, of the output signal of the measuring device (135, 510) is minimized;
**characterized in that**
- the control device (110-120, 145-160) is adapted to detect the object if the ratio of the alternating voltages does not correspond to the ratio of the distances of the measuring device (135, 510) from the transmitting coils (125, 130).

2. Measuring apparatus (100) according to one of the previous claims, **characterized in that** the alternating voltages are AC voltages that are phase-shifted to one another, in order to change the magnitude and phase of the magnetic fields of the transmitting coils (125, 130) periodically.

3. Measuring apparatus (100) according to Claim 1 or 2, **characterized in that**
- the measuring apparatus comprises a plurality of sensors (210, 220) spaced apart from one another for magnetic field determination,
- with the sensors (210, 220) being aligned with one another and connected to one another in such a way that output signals from the sensors (210, 220) add up to zero when the magnetic fields at the sensors (210, 220) are equal, and
- main field directions of the transmitting coils (125, 130) and preferred directions of the sensors (210, 220) are essentially parallel to one another.

4. Measuring apparatus (100) according to Claim 3, **characterized in that** the transmitting coils (125, 130) lie on top of each other in layers parallel to one another.

5. Measuring apparatus (100) according to Claim 3 or 4, **characterized in that** one of the sensors (210, 220) is surrounded by one of the transmitting coils (125, 130) and another of the sensors (210, 220) lies outside the transmitting coils (125, 130).

6. Measuring apparatus (100) according to Claim 1 or 2, **characterized in that**
- the measuring apparatus (100) comprises a sensor (510) for determining a magnetic field gradient,
- main field directions of the transmitting coils (125, 130) run parallel to each other, and
- a preferred direction of the sensor (510) runs essentially perpendicular or parallel to the main field directions.

7. Measuring apparatus (100) according to Claim 6, **characterized in that** the transmitting coils (125, 130) are arranged essentially next to one another in a layer and the preferred direction of the sensor (510) runs essentially parallel to this layer.

8. Measuring apparatus (100) according to Claim 6 or 7, **characterized in that** the transmitting coils (125, 130) are essentially D-shaped, with the backs of the D-shapes facing one another and the sensor (510) being arranged between the backs of the D-shapes.

9. Measuring apparatus (100) according to Claim 7 or 8, **characterized in that** the sensor (510) is arranged essentially in the layer of the transmitting coils (125, 130) and another sensor (510) is provided in a layer parallel to this layer, with preferred directions of the sensor (510) and the other sensor (510) being perpendicular or parallel to one other.

10. Measuring method (600) for detecting a metallic object (170), comprising the following steps:
- supply (610, 630) of two transmitting coils (125, 130) with alternating voltages in order to generate superimposed magnetic fields;
- determination (620) of an output signal, which is dependent on the magnetic field, of a magnetoresistive measuring apparatus in the region of the two magnetic fields;
- with the supply (610, 630) of the transmitting coils (125, 130) with alternating voltages taking place in such a way that the magnitude of an AC voltage component, which is synchronous with the alternating voltages, of the output signal of the measuring device (135, 510) is minimized; and
**characterized by**
- detection (640) of the object (170) if the ratio of the alternating voltages does not correspond to a ratio of the distances of the measuring device from the transmitting coils (125, 130).

11. Computer program product having program code means for performing the method (600) of Claim 10 if the computer program product runs on a processing device or is stored on a computer-readable data carrier.

## Revendications

1. Dispositif de mesure (100) destiné à détecter un objet métallique (170), le dispositif de mesure (100) comprenant les éléments suivants :
- deux bobines d'émission (125, 130) destinées à générer des champs magnétiques superposés ;
- un appareil de mesure magnétorésistif (135, 510) dans la zone des deux champs magnétiques destiné à délivrer un signal de sortie dépendant du champ magnétique ;
- un appareil de commande (110-120, 145-160) destiné à alimenter les bobines d'émission (125, 130) avec des tensions alternées de manière à réduire au minimum la valeur d'une composante de tension alternative du signal de sortie de l'appareil de mesure (135, 510) qui est en synchronisme d'horloge avec les tensions alternées ;
**caractérisé en ce que**
- l'appareil de commande (110-120, 145-160) est conçu pour détecter l'objet lorsque le rapport entre les tensions alternées ne correspond pas au rapport des écarts entre l'appareil de mesure (135, 510) et les bobines d'émission (125, 130).

2. Dispositif de mesure (100) selon l'une des revendications précédentes, **caractérisé en ce que** les tensions alternées sont des tensions alternatives déphasées l'une par rapport à l'autre afin de modifier périodiquement la valeur et la phase des champs magnétiques des bobines d'émission (125, 130).

3. Dispositif de mesure (100) selon la revendication 1 ou 2, **caractérisé en ce que**
- le dispositif de mesure comprend plusieurs capteurs (210, 220) servant à déterminer le champ magnétique qui sont espacés les uns des autres,
- les capteurs (210, 220) sont mutuellement orientés et reliés entre eux de telle sorte que les signaux de sortie des capteurs (210, 220) s'additionnent à zéro en présence de champs magnétiques identiques au niveau des capteurs (210, 220) et
- les directions de champ principal des bobines d'émission (125, 130) et les directions prédominantes des capteurs (210, 220) sont sensiblement parallèles les unes aux autres.

4. Dispositif de mesure (100) selon la revendication 3, **caractérisé en ce que** les bobines d'émission (125, 130) sont superposées l'une sur l'autre dans des plans mutuellement parallèles.

5. Dispositif de mesure (100) selon la revendication 3 ou 4, **caractérisé en ce que** l'un des capteurs (210, 220) est entouré par l'une des bobines d'émission (125, 130) et un autre des capteurs (210, 220) se trouve à l'extérieur des bobines d'émission (125, 130).

6. Dispositif de mesure (100) selon la revendication 1 ou 2, **caractérisé en ce que**
- le dispositif de mesure (100) comprend un capteur (510) servant à déterminer un gradient de champ magnétique,
- les directions de champ principal des bobines d'émission (125, 130) sont parallèles les unes aux autres et
- une direction prédominante du capteur (510) s'étend sensiblement perpendiculairement ou parallèlement aux directions de champ principal.

7. Dispositif de mesure (100) selon la revendication 6, **caractérisé en ce que** les bobines d'émission (125, 130) sont disposées sensiblement l'une à côté de l'autre dans un plan et la direction prédominante du capteur (510) s'étend sensiblement parallèlement à ce plan.

8. Dispositif de mesure (100) selon la revendication 6 ou 7, **caractérisé en ce que** les bobines d'émission (125, 130) sont sensiblement en forme de D, les dos des formes en D se faisant mutuellement face et le capteur (510) étant disposé entre les dos des formes en D.

9. Dispositif de mesure (100) selon la revendication 7 ou 8, **caractérisé en ce que** le capteur (510) est disposé sensiblement dans le plan des bobines d'émission (125, 130) et il existe un capteur supplémentaire (510) dans un plan parallèle à ce plan, les directions prédominantes du capteur (510) et du capteur supplémentaire (510) étant perpendiculaires ou parallèles les unes aux autres.

10. Procédé de mesure (600) destiné à détecter un objet métallique (170), comprenant les étapes suivantes :
- alimentation (610, 630) de deux bobines d'émission (125, 130) avec des tensions alternées afin de générer des champs magnétiques superposés ;
- détermination (620) d'un signal de sortie dépendant du champ magnétique d'un appareil de mesure magnétorésistif dans la zone des deux champs magnétiques ;
- l'alimentation (610, 630) des bobines d'émission (125, 130) avec des tensions alternées s'effectuant de telle sorte que la valeur d'une composante de tension alternative du signal de sortie de l'appareil de mesure (135, 510) qui est en synchronisme d'horloge avec les tensions alternées soit réduite au minimum ; et **caractérisé par**
- détection (640) de l'objet (170) lorsque le rapport entre les tensions alternées ne correspond pas à un rapport des écarts entre l'appareil de mesure et les bobines d'émission (125, 130).

11. Produit de programme informatique doté de moyens de code de programme pour mettre en oeuvre le procédé (600) selon la revendication 10 lorsque le produit de programme informatique est exécuté sur un appareil de traitement ou est enregistré sur un support de données lisible par ordinateur.
